# EUROPEAN PATENT SPECIFICATION

(11) **EP 2 336 388 B1**
(45) Date of publication and mention of the grant of the patent: **08.08.2012**
(21) Application number: 09015672.0
(22) Date of filing: 18.12.2009
(51) Int. Cl.: C23C 16/40, C03C 17/245, C03C 17/36

(54) **Method for deposition of a layer of a tin oxide onto a substrate**
Verfahren zum Auftragen einer Zinnoxidschicht auf ein Substrat
Procédé de dépôt d'une couche d'oxyde d'étain sur un substrat

(43) Date of publication of application: 22.06.2011
(73) Proprietor: centrotherm photovoltaics AG, 89143 Blaubeuren (DE)
(72) Inventor: Sheel, David William, Ormskirk Lancashire L39 5EB (GB); Schmid, Dieter, Dr., 80933 München (DE); Herbst, Wolfgang, Dr., 78464 Konstanz (DE)
(74) Representative: Heyerhoff & Geiger

(56) References cited:
- WO-A1-98/06675
- US-A- 4 880 664
- US-A- 5 487 784
- MATSUI ET AL: "Influence of alcohol on grain growth of tin oxide in chemical vapor deposition" THIN SOLID FILMS, ELSEVIER-SEQUOIA S.A. LAUSANNE, CH LNKD- DOI:10.1016/J.TSF.2006.07.173, vol. 515, no. 5, 18 January 2007 (2007-01-18), pages 2854-2859, XP005823885 ISSN: 0040-6090

## Description

The present invention relates to a method for depositing a layer of a tin oxide onto a substrate.

Tin oxide layers or films are highly transparent for visible light and have a low electrical resistivity which can even be lowered by doping the tin oxide films, for example with fluorine. Among other beneficial properties, tin oxide has a high mechanical hardness and is environmentally stable. Consequently, tin oxide films are used as transparent conductive oxides in various applications. For example, tin oxide films are used as conductive layers in photovoltaic cells, in gas sensors, in heating elements for aircraft windows and in displays. In most cases tin oxide films are produced and deposited by chemical vapour deposition (CVD) and partly by CVD at roughly atmospheric pressure (APCVD).

In some applications, it is desirable to have a good surface morphology control during the deposition of a tin oxide layer. Such control is necessary to produce an appropriate surface morphology of the deposited layer. For example, rather large or rather small structures formed at the surface of the deposited layer might be advantageous. Particularly in connection with photovoltaic applications such surface structures; often referred to as textures, are advantageous as they improve the trapping of incident light and in this way the conversion efficiency of a solar cell. In order to optimize the spectral response of the solar cell, the geometry of the texture has to be adapted to the individual solar cell type. In one case rather small structures might be advantageous, in another case improvements might be stronger when rather large structures are used. Such an adaption is particularly necessary for tandem solar cells.

A known technique for sufficiently controlling the morphology of a deposited tin oxide layer is to deposit a thick layer of tin oxide first and to build the desired surface structure in a second step by etching processes like wet etching in an aqueous etching solution or dry etching in a vacuum processes. This is rather involving and costly.

US 4,880,664 describes another possibility for providing a tin oxide layer with the desired properties. According to this disclosure a first tin oxide layer is formed by CVD from tin tetrachloride, water and a lower alcohol. Afterwards a second tin oxide layer is formed by CVD from tin tetrachloride and water. The resulting texture at the surface of the whole tin oxide layer formed out of the first and the second tin oxide layer is controlled primarily by selecting a proper ratio between the thickness of the first and the thickness of the second tin oxide layer. Two deposition processes are, however, time consuming and costly.

Against this background, the present invention is based on the problem to provide a low-complexity method to deposit a tin oxide layer having a surface structure onto a substrate.

This problem is solved by a method having the features of claim 1.

Dependent claims relate to advantageous developments.

The method according to the invention is based on the concept of providing in a reaction zone a gaseous mixture comprising a tin source, an oxygen source and an alcohol having the chemical formula CₓH_{y}OH, where x is equal to or greater than 4 and y is equal to or greater than 9, heating the substrate, and thereby in the reaction zone converting at a pressure of approximately atmospheric ambient pressure tin originating from the tin source and oxygen originating from the oxygen source to a tin oxide being deposited onto a surface of the substrate.

For the purposes of the present invention, reaction zone means an area, in which conditions like temperature etc. are such that tin originating from a tin source located in the reaction zone and oxygen originating from an oxygen source located in the reaction zone can be converted into tin oxide and such that said tin oxide can be deposited onto the surface of the substrate. In most cases the reaction zone will therefore be formed in the near neighbourhood of the substrate and may include the surface of the substrate itself. Furthermore, substrate means in principle anything a tin oxide layer can be deposited on. It might for example be a glass substrate with or without any layers deposited or formed on it before the deposition of the tin oxide layer. The substrate might, for example, be a float glass with a silicon oxide layer already formed on it. In this case, the surface of the substrate onto which the tin oxide is deposited, would be an upper surface of said silicon oxide layer.

For the purposes of the present invention approximately atmospheric ambient pressure means that the conversion of tin originating from the tin source and oxygen originating from the oxygen source to tin oxide takes place under a pressure having nearly the same pressure value as the atmospheric ambient pressure. The values might slightly differ due to gas flows within or out of the reactor or other effects. But in each case the reactor is not in any way evacuated and the pressure value at the substrate is not more than 50 mbar lower than the atmospheric ambient pressure. However, it might be more than 50 mbar higher.

Heating might be performed in the reaction zone or before the substrates are fed into the reaction zone. In the latter case the substrates have to be heated in such that their temperature at the time when they reach the reaction zone is still high enough to enable the described conversion in the reaction zone. In an advantageous embodiment this temperature in the reaction zone should be between 450 °C and 600 °C, preferably higher than 500 °C.

The method according to the invention reduces complexity of deposition of a tin oxide layer with a surface structure as only one deposition process is needed. Nevertheless the method according to the invention provides a good surface morphology control during the deposition of the tin oxide layer, i.e. the structuring or texturing of the surface of the deposited layer can be sufficiently controlled. In particular the size of the formed structures can be controlled. The good surface morphology control can be put down to the usage of higher alcohols with x equal to or greater than 4 and y equal to or greater than 9. The effect of adding such higher alcohols to the gaseous mixture varies with the kind of tin source used. The choice of alcohol is therefore crucial for optimizing the individual deposition process. It has been found that the usage of tin tetrachloride leads to lager structures as compared to the usage of tin sources with an organic group like mono-buyltin trichloride and dimethyltin dichloride. Furthermore, it has turned out that the surface morphology can be even better controlled if organo tin halides are used as tin source. The method according to the invention can be realized in stand-alone equipments for APCVD known from prior art and the method is easily applied in production lines for example in a production line for manufacturing thin film solar cells.

In a preferred embodiment of the invention the substrate is preheated before entering the reaction zone or even before entering an apparatus for carrying out the method according to the invention. The latter is especially advantageous for depositing tin oxide on glass on a glass float line either in the Float bath, Lehr gap or in the Lehr. Preheating might be performed in such that on entering the reaction zone the temperature of the substrate is still high enough to enable the described conversion of tin and oxygen into an tin oxide, so that no further heating of the substrates needs to be done. Or preheating might be performed in such that an additional heating within the reaction zone is necessary. In an embodiment of the invention according to the latter case, such an additional heating is performed in order to enable the desired conversion of tin originating from the tin source and the oxygen originating from the source of oxygen to a tin oxide.

The gaseous mixture is preferably delivered to the substrate to be coated in a laminar flow. In this way the homogeneity of the deposited tin oxide layers can be improved.

Until reaching the reaction zone, the gaseous mixture is advantageously kept at a temperature chosen such that gas phase reaction of the gaseous mixture is sufficiently controlled. That means that the gaseous mixture is kept at a temperature such that in the gaseous mixture the conversion of tin and of oxygen into tin oxide does not, or at least only to a non-relevant extent, take place until the gaseous mixture reaches the reaction zone. Advantageously, the gaseous mixture is kept at a temperature between 50 °C and 350 °C, preferably at a temperature between 100 °C and 200 °C, until it reaches the reaction zone.

In one embodiment of the method according to the invention a gaseous mixture that comprises a carrier gas is provided in the reaction zone. Preferably an inert gas like nitrogen or a noble gas like argon is used as carrier gas.

In a preferred embodiment a tin comprising precursor gas is premixed with an oxygen comprising precursor gas and/or the alcohol and the carrier gas. The resulting mixture is delivered into the reaction zone. In case that the oxygen comprising precursor gas and the alcohol are both premixed, the resulting mixture is the gaseous mixture. Advantageously, a gaseous component already contained in the tin and/or oxygen comprising precursor gas is used as carrier gas, so that no further carrier gas has to be added in order to obtain the desired gaseous mixture. Furthermore, also the alcohol may be contained already in the tin comprising precursor gas and/or the oxygen comprising precursor gas, so that only the two precursor gases have to premixed to obtain the gaseous mixture which is delivered into the reaction zone. It is also possible to premix the oxygen comprising precursor gas only with the alcohol and the carrier gas and to deliver the resulting mixture into the reaction zone. Obviously further variations of premixing constituents of the gaseous mixture are possible.

The tin comprising precursor gas may for example be obtained by bubbling the carrier gas through a heated tin comprising liquid. The oxygen comprising precursor gas may for example be obtained by flash evaporating a liquid comprising an oxygen source and the alcohol.

Instead of premixing precursor gases, it is also possible to form the gaseous mixture by mixing a tin comprising precursor gas with an oxygen comprising precursor gas, the alcohol and the carrier gas close to or in the reaction zone. Again, a gaseous component contained in the tin and/or oxygen comprising precursor gas is preferably used as carrier gas and the alcohol is even more preferably already contained in one of the two precursor gases.

According to a preferred embodiment of the invention, in all cases, precursor gases premixed, partially premixed or not premixed at all, at least one precursor gas is provided via at least one distribution head. Such distribution heads allow a controlled gas flow and are per se known from methods and apparatus of CVD. Preferably, temperature controlled distribution heads are used, which make it possible to improve uniformity of the deposited layer.

In the invention the alcohol is a branched or a cyclical alcohol. More preferably, the alcohol is either tert-butanol C₄H₉OH or cyclohexanol C₆H₁₁OH. Using these alcohols, rather high tin oxide growth rates can be realized.

Preferably, monobutyltin trichloride (MBTC), dimehtyltin dichloride (DMDTC) or tin tetrachloride (TTC) is used as tin source or as a constituent of the tin comprising precursor gas. At a temperature of approximately 20 °C and at a pressure of approximately atmospheric ambient pressure MBTC and TTC are liquid. A tin comprising precursor gas may be provided by heating MBTC to a temperature of for example 120 °C or TTC to a temperature of for example 90 °C and bubbling a carries gas, for example nitrogen, through the heated liquid.

In a further embodiment of the invention a doping agent is provided in the reaction zone for the purpose of depositing a layer of doped tin oxide onto the substrate. The doping agent may, for example, be already contained in the tin comprising precursor gas and/or the oxygen comprising precursor gas. Preferably a fluorine comprising doping agent such as trifluoroacetic acid, nitrogen fluoride or hydrogen fluoride is used.

The substrate is preferably moved during the doped or undoped tin oxide layer is deposited, as it has turned out that in this way the homogeneity of the deposited layer can be improved.

It has turned out that with the method according to the invention tin oxide layers with rounded surface structures can be deposited. This has proven to be particularly advantageous for photovoltaic applications, especially for the production of amorphous silicon thin film solar cells where tin oxide layers are used as front contact of the solar cell. In this case the forming of rounded surface structures reduces the risk of shunting a semiconducting layer arranged on top of the tin oxide layer. In this way electrical losses in the solar cell can be reduced. It has turned out that good light trapping in the solar cell can be realized despite of the rounding of the surface structure of the tin oxide layer. After optimization of the tin oxide layer even better light trapping than in tin oxide layers known from the state of the art can be realized.

Preferably, a tin oxide layer having a thickness within a range from 10 nm to 3000 nm, more preferably within a range from 450 nm to 1500 nm, is deposited onto the substrate.

In an advantageous embodiment of the invention the tin oxide layer is deposited onto a substrate as a transparent front contact of a solar cell. The deposited tin oxide layer may be doped or not. However, a fluorine doped tin oxide layer has proven to be particularly advantageous.

The invention will be explained in more detail below with reference to figures. Elements exercising essentially similar effects are, as far as this appears appropriate, marked with equal reference signs. The figures show:
- Fig. 1: Schematic illustration of a first embodiment of the method according to the invention
- Fig. 2: Schematic illustration of a second embodiment of the method according to the invention
- Fig. 3: Thin film solar cell according to the state of the art with a tin oxide layer as transparent front contact
- Fig. 4: Atomic force microscope picture of a tin oxide layer deposited with a method according to the invention
- Fig. 5: Atomic force microscope picture of a typical tin oxide layer deposited with a method according to the state of the art

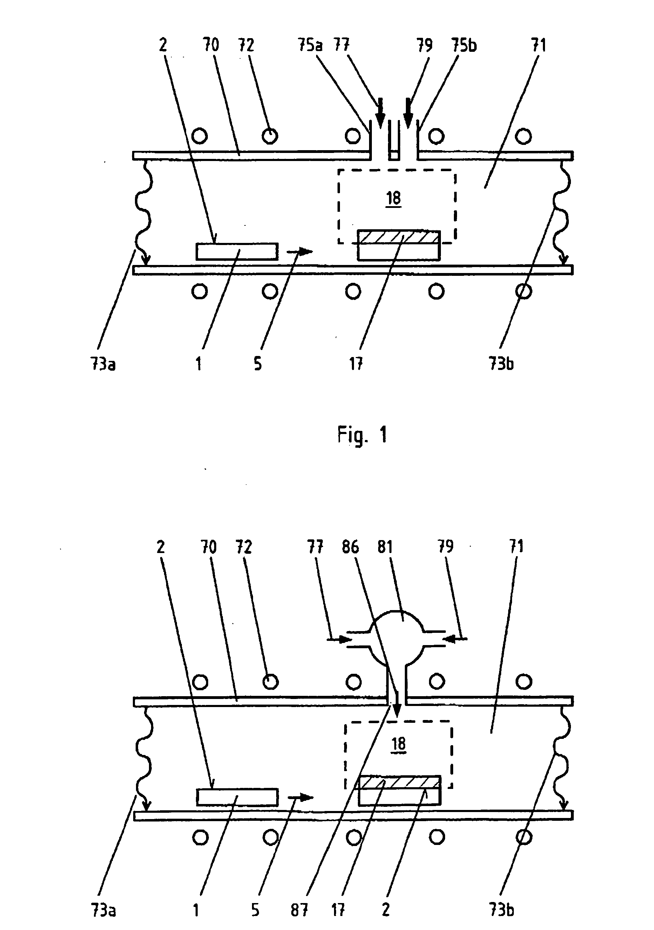

Figure 1 schematically illustrates a first embodiment of the method according to the invention. According to this embodiment, substrates 1 are introduced into a reactor 70. The reactor 70 comprises a heating device 72 for heating the substrates 1. In the embodiments of figures 1 and 2 external heating devices 72 are used. It is however obvious to a person skilled in the art that also internal heating devices arranged in a chamber 71 of the reactor 70 can be used. The reactor 70 comprises open ends, so that the substrates 1 can easily be transported into and through the reactor 70 as indicated by the direction of substrate transport 5. Said substrate transport is realized by means of a per se known transport device, e.g. a pull or push rod system or a conveyer-belt, which is depicted neither in figure 1 nor in figure 2 for the purpose of enhanced clarity. At the open ends of the reactor 70 gas locks 73a, 73b, particularly gas curtains, are provided in order to prevent intrusion of contaminations into the reactor 70.

According to figure 1 the substrates 1 are transported by the not depicted transport device in the direction of transport 5 into a reaction zone 18. By means of a gas inlet 75a a mixture of e.g. TTC and a carrier gas, e.g. nitrogen, are fed as a tin comprising precursor gas 77 into the reaction zone 18. By means of a gas inlet 75b an oxygen comprising precursor gas 79 is fed into the reaction zone 18. Said oxygen comprising precursor gas 79 further comprises an alcohol having the formula CₓH_{y}OH, where x ≥ 4 and y ≥ 9, and a carrier gas. This oxygen comprising precursor gas 79 might for example be generated by flash evaporating a solution of tert-butanol in water and using nitrogen as carrier gas. The precursor gases 77, 79 provided by the gas inlets 75a, 75b are mixed in the reaction zone 18, so that a gaseous mixture comprising a tin source, an oxygen source and the alcohol specified above is provided in the reaction zone 18. Due to the heating of the substrate 1 tin originating from the tin comprising precursor gas 77 and oxygen originating from the oxygen comprising precursor gas 79 are converted into tin oxide and deposited onto a surface 2 of the substrate 1 as a tin oxide layer 17.

Figure 1 shows two gas inlets 75a, 75b for the different precursor gases 77, 79. It is of course possible to provide more than two separate gas inlets for the different constituents of the gaseous mixture. For example, separate gas inlets can be provided for the carrier gas or the alcohol specified above. In this case everything fed into the reaction zone 18 via separate gas inlets would be mixed in the reaction zone 18 so that the desired gaseous mixture is obtained.

Figure 2 illustrates a further embodiment of the method according to the invention. The schematically depicted embodiment differs from the one of figure 1 in such that a premixing device 81 is provided in which the tin comprising precursor gas 77 and the oxygen comprising precursor gas 79 are premixed. As the carrier gas and the alcohol specified above are contained in the precursor gases 77, 79, premixing results in the desired gaseous mixture 86 which is fed into the reaction zone 18 via a per se known distribution head 87. In the reaction zone 18 again tin originating from the tin comprising precursor gas 77 and oxygen originating from the oxygen comprising precursor gas 79 are converted into tin oxide and deposited onto a surface 2 of the substrate 1 as tin oxide layer 17. Of course it is also possible to feed some or all constituents of the gaseous mixture separately into the premixing device, so that no or less precursor gases would have to be provided.

If the oxygen comprising precursor gas 79 is generated by flash evaporating a solution of hydrogen fluoride and tert-butanol in water, a fluorine comprising doping agent is provided in the reaction zone so that doped tin oxide layers are deposited. Obviously also other doping agents can be used and provided in the reaction zone in different ways.

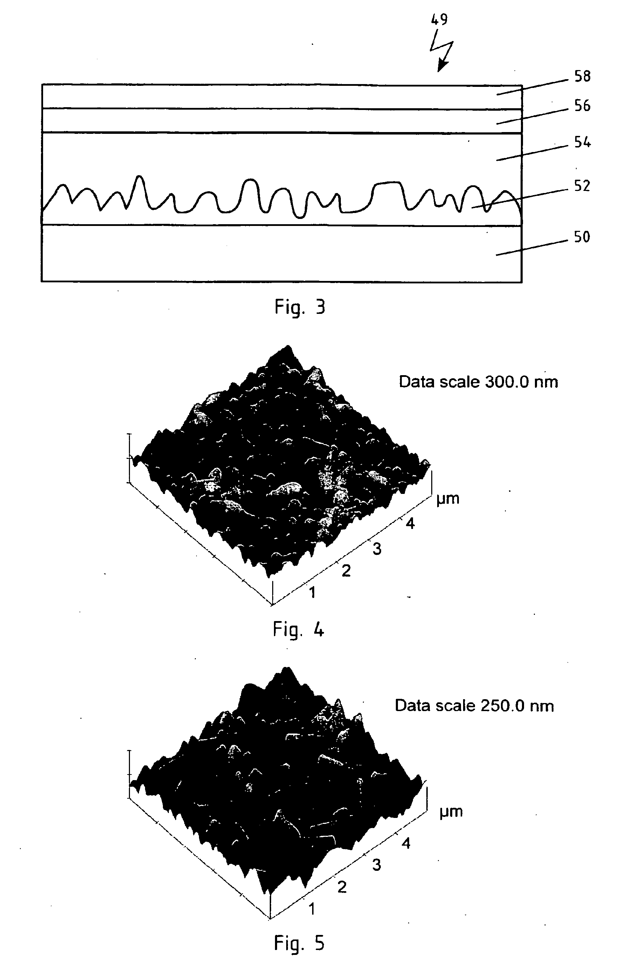

Such a doped tin oxide layer can advantageously be deposited as a transparent front contact of a solar cell. For example a doped or undoped tin oxide layer may be deposited as transparent front contact of a compound semiconductor solar cell, e.g. of a copper indium gallium selenide solar cell or a cadmium telluride solar cell. Particularly advantageously, however, the doped tin oxide layer is deposited as transparent front contact of a microcrystalline silicon solar cell or of an amorphous silicon solar cell 49, as it is schematically illustrated in figure 3. According to this illustration, a fluorine doped tin oxide layer 52 is deposited onto a glass substrate 50. The deposition is realized using the method according to the invention so that the doped tin oxide layer 52 comprises a surface structure with rounded structures as it is schematically indicated in figure 3. The fluorine doped tin oxide layer 52 forms a front contact of the solar cell 49 and is covered by an amorphous silicon layer 54, which is doped in order to form a per se known and not depicted pin-doping. A further transparent conducting oxide layer 56 is arranged on top of the amorphous silicon layer 54. This further transparent conducting oxide layer 56 can again be deposited using the method according to the invention or by a different deposition process. Particularly, another transparent conducting oxide than tin oxide can be used. A metallic layer is arranged on top of the further transparent conducting oxide layer 56 and forms the metallic back contact 58 of the solar cell 49.

In a preferred embodiment of the invention a fluorine doped tin oxide layer is deposited onto a substrate, preferably onto a glass substrate, in the following way: A tin comprising precursor gas is provided by heating MBTC to a temperature of about 120 °C and nitrogen is bubbled through the liquid MBTC. An oxygen, fluorine and tert-butanol comprising precursor gas is provided by flash evaporating an aqueous solution having 2 mol% trifluoroacetic acid and 2 mol% tert-butanol and using nitrogen as a carrier gas. Consequently, both precursor gases comprise nitrogen as carrier gas and the oxygen comprising precursor gas further comprises the alcohol tert-butanol and the fluorine comprising doping agent. The two precursor gases are premixed, for example as described in connection with figure 2, and provided in the reaction zone via a temperature controlled distribution head, e.g. via the distribution head 87 in figure 2. By means of said temperature controlled distribution head, the gaseous mixture is fed into the reaction zone at a temperature of about 130 °C and delivered to the substrate to be coated in a laminar flow. A total gas flow of about 2 1/min with 3% MBTC by volume has proven adequate. Deposition is performed under approximately atmospheric ambient pressure. The substrate is heated to a temperature of 550 °C so that the tin oxide deposition takes place within the reaction zone.

A doped or undoped tin oxide layer deposited in this way comprises the described advantageous rounded surface structures. These rounded structures can be recognized in figure 4 which shows an atomic force microscope picture of a part of the deposited tin oxide layer. The rounding of the surface structures becomes apparent in comparison to figure 5 which shows an atomic force microscope picture of a tin oxide layer that has been deposited according to the state of the art using methanol (CH₃OH) as an alcohol. In figure 5 sharp spikes can be recognized which are typical for the usage of methanol. In figure 4, instead, the structure is rounded and the risk of shunting a semiconducting layer deposited onto the tin oxide layer is reduced.

As mentioned above, the light trapping in a solar cell can be improved by providing a tin oxide layer deposited using the method according to the invention as a transparent front contact of the solar cell. This illustrates the following table, in which characteristic data of a tin oxide layer is given that has been deposited with the method described in connection with figure 4, besides that cyclohexanol has been used instead of tert-butanol. For comparative purposes corresponding data of a tin oxide layer that has been deposited according to the state of the art using methanol as alcohol is also given.

| | Layer thick-ness in nm | RMS in nm | Transmittance in % | Scatter in % |
|---|---|---|---|---|
| Cyclohexanol | 775 | 37 | 79 | 8,7 |
| Methanol | 740 | 32 | 79 | 3,8 |

In this table RMS is the root mean square roughness of the surface structure of the tin oxide layers. Scatter is defined as the ratio of the intensity of light which is scattered forward through the sample divided by the total intensity of light transmitted forward through the sample. The given values refer to the wavelength spectrum between 400 nm and 800 nm. As the table shows, values are quite similar. As roughness increases with layer thickness, it is not surprising that the tin oxide layer deposited using cyclohexanol is slightly rougher. However, the scatter value is significantly higher for the tin oxide layer deposited using cyclohexanol. This shows that light trapping within a solar cell can be improved by depositing a tin oxide layer as a transparent front contact of a solar cell using the method according to the invention.

List of Reference Numbers
- 1: Substrate
- 2: Surface of substrate
- 5: Direction of substrate transport
- 17: Tin oxide layer
- 18: Reaction zone

- 49: Solar cell
- 50: Glass substrate
- 52: Fluorine doped tin oxide layer
- 54: Amorphous silicon layer
- 56: Further transparent conducting oxide layer
- 58: Metallic back contact

- 70: Reactor
- 71: Chamber
- 72: Heating device
- 73a: Gas lock
- 73b: Gas lock
- 75a: Gas inlet
- 75b: Gas inlet
- 77: Tin comprising precursor gas
- 79: Oxygen and alcohol comprising precursor gas

- 81: Premixing device
- 86: Gaseous mixture
- 87: Distribution head

## Claims

1. Method for depositing a layer of a tin oxide (17) onto a substrate (1), the method comprising the steps of
- providing in a reaction zone (18) a gaseous mixture (86) comprising a tin source (77), an oxygen source (79) and an alcohol (79) having the chemical formula CₓH_{y}OH, where x is equal to or greater than 4 and y is equal to or greater than 9,
- heating the substrate, and
- thereby in the reaction zone (18) converting at a pressure of approximately atmospheric ambient pressure tin originating from the tin source (77) and oxygen originating from the oxygen source (79) to a tin oxide (17) being deposited onto a surface (2) of the substrate (1)
**characterised in that** said alcohol in selected from the group consisting of a branched or a cyclical alcohol.

2. Method according to claim 1, wherein an element selected from the group consisting of tin tetrachloride, monobutyltin trichloride and dimethyltin dichloride is used as tin source.

3. Method according to any of the preceding claims, wherein the branched or cyclical alcohol used is tert-butanol or cyclohexanol.

4. Method according to any of the preceding claims, wherein a gaseous mixture (86) comprising at least one carrier gas is provided.

5. Method according to claim 4, wherein
a tin comprising precursor gas (77) is premixed with an oxygen comprising precursor gas (79) and the alcohol (79) and with the carrier gas and the resulting mixture (86) is delivered into the reaction zone (18).

6. Method according to claim 4, wherein
the oxygen comprising precursor gas (79) is premixed with the alcohol (79) and with the carrier gas and the resulting mixture (86) is delivered into the reaction zone (18).

7. Method according to claim 4, wherein
the gaseous mixture is formed by mixing a tin comprising precursor gas (77) with an oxygen comprising precursor gas (79), the alcohol (79) and the carrier gas close to or in the reaction zone (18).

8. Method according to any of claims 5 to 7, wherein
a gaseous component contained in the tin comprising precursor gas (77) and the oxygen comprising precursor gas (79) is used as carrier gas.

9. Method according to any of claims 5 to 8, wherein an oxygen comprising precursor gas (79) is used that further comprises the alcohol.

10. Method according to any of the preceding claims, wherein a doping agent is provided in the reaction zone (18) for the purpose of depositing layer of doped tin oxide onto the substrate (1).

11. Method according to claim 10, wherein
the doping agent is premixed with at least one element selected from the group consisting of a tin comprising precursor gas, an oxygen comprising precursor gas (79), the alcohol and a carrier gas.

12. Method according to claim 10 or 11,
wherein a fluorine comprising doping agent selected from the group consisting of trifluoroacetic acid, nitrogen fluoride and hydrogen fluoride is used.

13. Method according to any of the preceding claims, wherein the tin oxide layer (52) is deposited as a transparent front contact (52) of a solar cell (49).

14. Method according to claims 13 and 12, wherein
a fluorine doped tin oxide layer (52) is deposited as a transparent front contact (52) of a solar cell (49).

## Patentansprüche

1. Verfahren zur Abscheidung einer Zinnoxidschicht (17) auf einem Substrat (1) aufweisend die Schritte des
- Zurverfügungstellens einer eine Zinnquelle (77), eine Sauerstoffquelle (79) und einen Alkohol (79) mit der chemischen Formel CₓH_{y}OH aufweisenden gasförmigen Mischung (86) in einer Reaktionszone (18), wobei x größer oder gleich 4 ist und y größer oder gleich 9 ist,
- Erhitzens des Substrats und
- hierdurch Umsetzens von Zinn stammend von der Zinnquelle (77) und von Sauerstoff stammend von der Sauerstoffquelle (79) in der Reaktionszone (18) bei einem Druck von ungefähr atmosphärischem Umgebungsdruck zu einem auf einer Oberfläche (2) des Substrats (1) abgeschiedenen Zinnoxid (17),
**dadurch gekennzeichnet,**
**dass** der genannte Alkohol ausgewählt wird aus der Gruppe bestehend aus einem verzweigten oder einem zyklischen Alkohol.

2. Verfahren nach Anspruch 1, bei welchem ein Element ausgewählt aus der Gruppe bestehend aus Zinntetrachlorid, n-Butylzinntrichlorid und Dimethylzinndichlorid als Zinnquelle verwendet wird.

3. Verfahren nach einem der vorangegangenen Ansprüche,
bei welchem der verwendete verzweigte oder zyklische Alkohol tert-Butanol ist.

4. Verfahren nach einem der vorangegangen Ansprüche,
bei welchem eine gasförmige Mischung (86) zur Verfügung gestellt wird, welche wenigstens ein Trägergas aufweist.

5. Verfahren nach Anspruch 4,
bei welchem ein Zinn aufweisendes Präkursorgas (77) mit einem Sauerstoff aufweisenden Präkursorgas (79) und dem Alkohol (79) mit dem Trägergas vorgemischt wird, und die resultierende Mischung (86) in die Reaktionszone (18) eingeleitet wird.

6. Verfahren nach Anspruch 4,
bei welchem das Sauerstoff aufweisende Präkursorgas (79) mit dem Alkohol (79) und mit dem Trägergas vorgemischt wird, und die resultierende Mischung (86) in die Reaktionszone (18) eingeleitet wird.

7. Verfahren nach Anspruch 4,
bei welchem die gasförmige Mischung gebildet wird, indem in der Nähe der Reaktionszone (18) oder in der Reaktionszone (18) ein Zinn aufweisendes Präkursorgas (77) mit einem Sauerstoff aufweisenden Präkursorgas (79), dem Alkohol (79) und dem Trägergas gemischt wird.

8. Verfahren nach einem der Ansprüche 5 bis 7,
bei welchem ein in dem Zinn aufweisenden Präkursorgas (77) und dem Sauerstoff aufweisenden Präkursorgas (79) enthaltener gasförmiger Bestandteil als Trägergas verwendet wird.

9. Verfahren nach einem der Ansprüche 5 bis 8,
bei welchem ein Sauerstoff aufweisendes Präkursorgas (79) verwendet wird, welches darüber hinaus den Alkohol aufweist.

10. Verfahren nach einem der vorangegangenen Ansprüche,
bei welchem zum Zwecke der Abscheidung einer dotierten Zinnoxidschicht auf dem Substrat (1) ein Dotierstoff in der
Reaktionszone (18) zur Verfügung gestellt wird.

11. Verfahren nach Anspruch 10,
bei welchem der Dotierstoff vorgemischt wird mit wenigstens einem Element ausgewählt aus der Gruppe bestehend aus einem Zinn aufweisenden Präkursorgas (77), einem Sauerstoff aufweisenden Präkursorgas (79), dem Alkohol und einem Trägergas.

12. Verfahren nach Anspruch 10 oder 11,
bei welchem ein Fluor aufweisender Dotierstoff ausgewählt aus der Gruppe bestehend aus Trifluoressigsiure, Stickstofffluorid und Fluorwasserstoff verwendet wird.

13. Verfahren nach einem der vorangegangenen Ansprüche,
bei welchem die Zinnoxidschicht (52) als transparenter Frontkontakt (52) einer Solarzelle (49) abgeschieden wird.

14. Verfahren nach Ansprüchen 12 und 13,
bei welchem eine Fluor-dotierte Zinnoxidschicht (52) als transparenter Frontkontakt (52) einer Solarzelle (49) abgeschieden wird.

## Revendications

1. Procédé pour déposer une couche d'oxyde d'étain (17) sur un substrat (1), le procédé comprenant les étapes de:
- prévoir dans une zone de réaction (18) un mélange gazeux (86) comprenant une source d'étain (77), une source d'oxygène (79) et un alcool (79) ayant la formule chimique CₓH_{y}OH dans laquelle x est égal ou supérieur à 4 et y est égal ou supérieur à 9,
- chauffer le substrat et
- convertir ainsi dans la zone de réaction (18) à une pression qui est approximativement la pression atmosphérique ambiante l'étain provenant de la source d'étain (77) et l'oxygène provenant de la source d'oxygène (79) en un oxyde d'étain (17) qui est déposé sur une surface (2) du substrat (1),
**caractérisé en ce**
**que** ledit alcool est sélectionné dans le groupe composé d'un alcool ramifié ou un alcool cyclique.

2. Procédé selon la revendication 1 dans lequel un élément sélectionné dans le groupe composé du tétrachlorure d'étain, du trichlorure de monobutylétain et du dichlorure de diméthylétain est utilisé comme source d'étain.

3. Procédé selon l'une quelconque des revendications précédentes dans lequel l'alcool ramifié ou l'alcool cyclique utilisé est le tert-butanol ou le cyclohexanol.

4. Procédé selon l'une quelconque des revendications précédentes dans lequel un mélange gazeux (86) comprenant au moins un gaz porteur est prévu.

5. Procédé selon la revendication 4 dans lequel un gaz précurseur comprenant de l'étain (77) est prémélangé avec un gaz précurseur comprenant de l'oxygène (79) et l'alcool (79) et avec le gaz porteur et le mélange résultant (86) est amené dans la zone de réaction (18).

6. Procédé selon la revendication 4 dans lequel le gaz précurseur comprenant de l'oxygène (79) est prémélangé avec l'alcool et avec le gaz porteur et le mélange résultant (86) est amené dans la zone de réaction (18).

7. Procédé selon la revendication 4 dans lequel le mélange gazeux est formé en mélangeant un gaz précurseur comprenant de l'étain (77) avec un gaz précurseur comprenant de l'oxygène (79), l'alcool (79) et le gaz porteur près du ou dans la zone de réaction (18).

8. Procédé selon l'une quelconque des revendications 5 à 7 dans lequel un composant gazeux contenu dans le gaz précurseur comprenant de l'étain (77) et le gaz précurseur comprenant de l'oxygène (79) est utilisé comme gaz porteur.

9. Procédé selon l'une quelconque des revendications 5 à 8 dans lequel un gaz précurseur comprenant de l'oxygène (79) est utilisé qui comprend de plus l'alcool.

10. Procédé selon l'une quelconque des revendications précédentes dans lequel un agent dopant est prévu dans la zone de réaction (18) dans le but de déposer une couche d'oxyde d'étain dopé sur le substrat (1).

11. Procédé selon la revendication 10 dans lequel l'agent dcpant est prémélangé avec au moins un élément sélectionné dans le groupe comprenant un gaz précurseur comprenant de l'étain, un gaz précurseur comprenant de l'oxygène (79), l'alcool et un gaz porteur.

12. Procédé selon la revendication 10 ou 11 dans lequel un agent dopat comprenant du fluor sélectionné dans le groupe comprenant l'acide trifluoroacétique, le fluorure d'azote et le fluorure d'hydrogène est utilisé.

13. Procédé selon l'une quelconque des revendications précédentes dans lequel la couche d'oxyde d'étain (52) est déposée comme un contact avant transparent (52) d'une cellule solaire (49).

14. Procédé selon les revendications 13 et 12 dans lequel une couche d'oxyde d'étain dopée au fluor (52) est déposée comme un contact avant transparent (52) d'une cellule solaire (49).
